# EUROPEAN PATENT APPLICATION

(11) **EP 4 712 137 A1**
(43) Date of publication of application: **18.03.2026**
(21) Application number: 24199705.5
(22) Date of filing: 11.09.2024
(51) Int. Cl.: H01L 23/367, H01L 23/467

(54) **HEAT SINK WITH IMPROVED CONVECTION**

(71) Applicant: ABB SCHWEIZ AG, 5400 Baden (CH)
(72) Inventor: CHEERLA, Srinivasa Rao, 40477 Düsseldorf (DE); SOLOGUBENKO, Oleksandr, 8906 Bonstetten (CH); MOLITOR, Francoise, 8057 Zürich (CH)
(74) Representative: Zimmermann & Partner Patentanwälte mbB

(57) **Abstract**

A heat sink, comprising a plurality of fixed fins; a plurality of flexible flaps arranged between the fixed fins; wherein at least one of the flexible flaps comprises a magnet attached to or embedded in at least one of the flexible flaps.

## Description

### TECHNICAL FIELD

Embodiments of the present disclosure relate to a heat sink. Further embodiments relate to an electric power system equipment and a method of cooling an electric conductor.

### BACKGROUND

Electric resistance in electric conductors can create a considerable amount of heat. To ensure safe operating conditions, heat should be removed from the electric conductor. Especially at electric connections, heat created by additional contact resistance may influence a safe operation of electric equipment. Traditionally, heat dissipation elements, such as heat sinks, rely on passive flow phenomena to remove heat from the surface of the heat dissipation elements. The passive flow may be supplemented by fan-like devices. However, those fan-like devices typically require an additional energy supply.

Thus, heat sinks with an improved convection may be desired.

### DISCLOSURE OF THE INVENTION

In the view of the foregoing, the present disclosure is directed to a heat sink, an electric power system equipment comprising an electric conductor and a method of cooling an electric conductor.

According to an aspect of the present disclosure, a heat sink is provided. The heat sink comprises a plurality of fixed fins; a plurality of flexible flaps arranged between the fixed fins; wherein at least one of the flexible flaps comprises a magnet attached to or embedded in at least one of the flexible flaps.

According to another aspect of the present disclosure, an electric power system equipment comprising an electric conductor, wherein a heat sink according to embodiments described herein is in thermal contact with the electric conductor, is provided.

According to another aspect of the present disclosure, a method of cooling an electric conductor is provided. The method comprises determining an alternating current, AC, frequency of a current flowing through the electric conductor; providing a heat sink according to any of the embodiments described herein wherein the resonance frequency of at least one of the plurality of flexible flaps comprises a resonance frequency substantially equal to the AC frequency; establishing a thermal contact between the electric conductor and the heat sink; and positioning the heat sink such that the magnet is arranged substantially perpendicular to the magnetic field generated by a current flowing through the electric conductor.

According to some embodiments, the heat sink has a plurality of fixed fins. In particular, the heat sink may have at least 3, at least 5, at least 8, or at least 10 fixed fins. The heat sink may have at most 12, at most 15, at most 25 or at most 50 fixed fins. Typically, at least a majority of the plurality of fixed fins, and in particular each of the plurality of fixed fin, share the same geometry. The plurality of fixed fins typically includes aluminum or copper. In some embodiments, the plurality of fixed fins includes a plastic or stainless steel. Typically, the plurality of fixed fins has substantially the same material composition for each of the plurality of fixed fins. The fixed fins may have a thickness of at least 1 mm, at least 5 mm, or at least 1 cm. Typically, the fixed fins may have a thickness of at most 2 cm, or at most 5 cm.

According to some embodiments, the heat sink has a base plate. In particular, the base plate supports the plurality of fixed fins. The plurality of fixed fins may be arranged on the base plate according to a predetermined pattern. Exemplarily, the plurality of fixed fins may be arranged parallelly with respect to each other. Typically, the fixed fins extend substantially perpendicularly to the base plate. In some embodiments, the plurality of fixed fins may have a distance to the closest other fixed fin of at least 1 mm, at least 5 mm, at least 1 cm or at least 2 cm. Typically, the plurality of fixed fins may have a distance to the closest other fixed fin of at most 5 cm, or at most 10 cm. In some embodiments, the fixed fins have a length, as measured perpendicular to the base plate, of at least 1 cm, at least 2 cm or at least 5 cm. The fixed fins may have a length of at most 10 cm, at most 20 cm or at most 50 cm.

According to some embodiments, the heat sink has a plurality of flexible flaps. Typically, the flexible flaps include stainless steel, spring steel, or plastic. Flexible flaps including stainless steel may advantageously exhibit a reduced wear. In typical embodiments, the flexible flaps have a thickness of at least 0.05 mm, at least 0.1 mm, at least 0.2 mm or at least 0.3 mm. Typically, the flexible flaps have a thickness of at most 0.8 mm, at most 1 mm, or at most 1.5 mm. Typically, the flexible flaps have a plate-like shape. Typically, the flexible flaps provide a flexibility perpendicular to a main surface of the flexible flaps. The flexible flaps may have a Young modulus of at least 20 GPa. The flexible flaps may have a Young Modulus of at most 300 GPa. Typically, the flexible flaps have a Young modulus of 150 GPa to 250 GPa, and particularly of about 200 GPa. Typically, the flexible flaps have a length, particularly as measured perpendicular to the base plate, of at least 0.5 cm, at least 1 cm, at least 2 cm or at least 5 cm. The flexible flaps may have a length of at most 10 cm, at most 20 cm or at most 50 cm.

According to some embodiments, the plurality of flexible flaps is arranged between the fixed fins. Typically, for each of the plurality of flexible flaps, one of the plurality of fixed fins is arranged at a closer distance than the closest other flexible flap. Typically, at least some of the plurality of fixed fins is arranged between each pair of the plurality of flexible flaps. Typically, at least some of the plurality of flexible flaps is arranged between each pair of the plurality of fixed fins. In other words, the plurality of fixed fins and the plurality of flexible flaps is arranged substantially alternatingly in at least one direction. Arranging the plurality of fixed fins and the plurality of flexible fins substantially alternatingly may allow a uniform distribution of the convection enhancement.

According to some embodiments, the flexible flaps are arranged substantially parallel to the fixed fins. In particular, the flexible flaps are arranged substantially parallel in a non-operating configuration. During operation, the flexible flaps are typically oscillating around their equilibrium position and may reach non-parallel positions with respect to the fixed fins. In some embodiments, the flexible flaps may be arranged in a non-parallel position. In particular, the flexible flaps may be arranged substantially perpendicular to the fixed fins. In an operating environment, the orientation of the flexible flaps is typically determined by an alternating current (AC) carrying conductor to be cooled. Typically, the heat sink may be arranged accordingly. However, in some mounting conditions, the preferred orientation of the fixed fins, exemplarily due to air flows within a housing and the preferred orientation of the flexible flaps, associated with the orientation of the AC carrying conductor, may differ. A parallel arrangement of flexible flaps and fixed fins may advantageously provide a higher convection. However, as discussed above, a non-parallel arrangement, and in particular a perpendicular arrangement, of flexible flaps and fixed fins, that may be associated with a reduced performance, may allow to implement a convection improvement according to the embodiments described herein in specific mounting conditions where otherwise an implementation may not be possible.

In some embodiments, the flexible flaps do not extend beyond a contour defined by the fixed fins. In particular, the fixed fins may define a contour of at least part of the heat sink. Typically, the contour may be defined by the ends of the fixed fins and by the base plate. The contour is formed by imaginarily connecting the ends of the fixed fins or by imaginarily connecting the outermost ends of the plurality of fixed fins. Typically, the flexible flaps do not extend beyond the ends of the fixed fins and/or the outer most ends of the plurality of fixed fins. The flexible flaps not extending beyond the contour defined by the fixed fins advantageously allows to ensure a mechanical protection of the flexible flaps. The flexible flaps not extending beyond the contour defined by the fixed fins may advantageously allow to replace existing conventional heat sinks by heat sinks according to embodiments described herein without a changing mounting space. The flexible flaps not extending beyond the contour defined by the fixed fins may advantageously avoid changes in dielectric properties of the heat sink, in particular with respect to the heat sink being used in conjunction with an electric conductor.

At least one of the flexible flaps has a magnet. The magnet may be attached to the at least one flexible flap or may be embedded in the at least one flexible flap. The magnet being attached to or being embedded in the at least one flexible flap may have any mechanical connection ensuring that the flexible flap follows a mechanical motion of the magnet and vice versa. Exemplarily, the magnet may be glued, taped, welded, soldered, screwed, riveted or otherwise fastened to the at least one flexible flap. The magnet being embedded in the at least one flexible flap may include the magnet being arranged in a recess or grove of the at least one flexible flap or may include the magnet being completely enclosed by the at least one flexible flap. The magnet being embedded in the flexible flap can have the effect that the magnet is protected against external mechanical influence. However, with a magnet being attached to the flexible flap, the magnet may be replaced and/or installed more conveniently and with less effort. In some embodiments, a plurality of the plurality of flexible flaps, and in particular each of the flexible flaps, has a magnet. Typically, each of the plurality of flexible flaps has at most one magnet.

Typically, the magnet may be a permanent magnet. The magnet typically includes a ferromagnetic material. In particular, the magnet may include a ferromagnet. The magnet may have a magnetic moment, in particular a permanent magnetic moment. Typically, for a plurality of flexible flaps with each comprising a magnet, the magnetic moments of each of the magnets is substantially parallel.

In some embodiments, at least one of the flexible flaps has a resonance frequency. Typically, the resonance frequency of the flexible flaps is substantially equal to a mains frequency of an electrical power grid. The resonance frequency being substantially equal to the mains frequency improves the performance of the heat sink. In particular, the resonance frequency of the at least one flexible flap is substantially 16.7 Hz, 25 Hz, 50 Hz or 60 Hz. Typically, the resonance frequency of the at least one flexible flap may deviate from the mains frequency by at most 10%, at most 8%, at most 5%, at most 2% or at most 1%; preferably, the resonance frequency of the at least one flexible flap may deviate from the mains frequency by at most 2%. The mains frequency may be understood as the average frequency or as the nominal frequency of the electrical power grid. In some embodiments, each of the plurality of flexible flaps has substantially the same resonance frequency.

In some embodiments, the plurality of flexible flaps includes a first flexible flap and a second flexible flap. The first flexible flap may have a first property and the second flexible flap may have a second property different from the first property. In particular, the first flexible flap may have a first length and the second flexible flap may have a second length different from the second length. In particular, the second length may be shorter or longer than the first length. In some embodiments, the first flexible flap may have a first width and the second flexible flap may have a second width different from the first width. In particular, the second width may be broader or narrower than the first width. In some embodiments, the first flexible flap may have a first thickness and the second flexible flap may have a second thickness different from the first thickness. In particular, the second thickness may be larger or smaller than the first thickness. The plurality of flexible flaps having different properties for the first flexible flap and for the second flexible flap may provide an improved convection at a plurality of operating conditions, in particular with respect to different settings of the alternating current, exemplarily with respect to the frequency or the amplitude of the alternating current.

In some embodiments, the first flexible flap may include a first material and the second flexible flap may include a second material different from the first material. In some embodiments, the first flexible flap has a first resonance frequency and the second flexible flap has a second resonance frequency different from the first resonance frequency. In particular, the second resonance frequency may differ from the first resonance frequency by at least 5% or by at least 10%. Exemplarily, the first resonance frequency may be substantially 50 Hz and the second resonance frequency may be substantially 60 Hz. The first flexible flap having a first property and the second flexible flap having a second property different from the first property may advantageously allow to apply the heat sink for electric power system equipment optimized for or operating at different operating conditions, exemplarily with respect to the frequency or the current intensity of the electric current flowing through the electric power system equipment.

In some embodiments, at least one alignment magnet is attached to or embedded in at least one of the fixed fins. In particular, the alignment magnet may be attached to or embedded in an outermost fixed fin. The alignment magnet may be glued, taped, welded, soldered, screwed, riveted or otherwise fastened to the at least one fixed fin. The alignment magnet being embedded in the at least one fixed fin may include the alignment magnet being arranged in a recess or grove of the at least one fixed fin or may include the alignment magnet being completely enclosed by the at least one fixed fin. In some embodiments, a plurality of the plurality of fixed fins each has an alignment magnet. Typically, the alignment magnet includes a ferromagnetic material. In particular, the alignment magnet may include a ferromagnet.

Typically, the alignment magnet has a magnetic moment substantially parallel to the magnetic moment of the magnet of the flexible flaps. The alignment magnet typically advantageously balances magnetic fields of the flexible flaps and potentially of other magnetic field sources present, exemplarily originating from nearby devices. The alignment magnet may in particular advantageously avoid the flexible flaps contacting the fixed fins and sticking to the fixed fins.

Typically, the heat sink according to embodiments described herein is employed to cool an electric conductor. The electric conductor is typically part of an electric power system equipment. In some embodiments, the electric conductor may be part of an electric power user, such as a machine, a vehicle, in particular a rail vehicle, or a consumer device. The electric power system equipment may in particular be a switchgear. Typically, the electric power system equipment is an alternating current (AC) electric power system equipment. In some embodiments, the electric conductor includes an electrical connection, in particular between components of the electric power system equipment. The electrical connection may have a contact resistance, that may lead to a particularly high resistance heating. In some embodiments, the contact resistance may include a surface impurity resistance.

In some embodiments, the heat sink is in thermal contact with the electric conductor. In particular, the heat sink may be in a direct physical contact with the conductor or a housing of the conductor. In some embodiments, the heat sink may be in thermal contact with the conductor via a heat-transfer device, exemplarily a heat pipe. Typically, the heat sink is electrically isolated from the electric power system equipment and particularly from the electric conductor. In some embodiments, the heat sink is at the same electric potential as the electric conductor, and particularly electrically connected with the electric conductor.

Typically, the current flowing through the electric conductor is an alternating current (AC). The current flowing through the electric conductor causes a magnetic field in the vicinity of the electric conductor. For an alternating current, the magnetic field is an alternating magnetic field. Typically, the heat sink is arranged with respect to the electric conductor such that the permanent magnetic moment of the magnet of the at least one flexible flap is arranged at an angle of at least 5°, at least 15°, at least 30°, at least 45°, at least 60°, at least 75°, at least 85° or substantially perpendicular with respect to the magnetic field generated by the current flowing through the electric conductor. Advantageously, the permanent magnetic moment of the magnet of the at least one flexible flap is arranged substantially perpendicular with respect to the magnetic field generated by the current flowing through the electric conductor to obtain the largest force acting upon the magnet. Arranging the permanent magnetic moment of the magnet substantially perpendicular with respect to the magnetic field generated by the current advantageously increases the force acting upon the magnet, and thus acting upon the flexible flap. In some embodiments, a non-perpendicular arrangement may be preferred, exemplarily due to mounting conditions.

In some embodiments, the alternating current passing though the electric conductor causes at least one of the flexible flaps to oscillate. In particular, the alternating magnetic field generated by the alternating current causes an alternating force acting upon the magnet attached to or embedded in at least one of the flexible flaps. Typically, the flexible flap oscillates at the frequency of the alternating current.

Typically, in operation, an oscillation of the flexible flaps, in particular for embodiments in which each flexible flap includes a magnet, an oscillation of the flexible flaps causes a reduction of the temperature of the electric conductor of at least 1 K, at least 3 K, at least 5 K, at least 7 K or at least 10 K. The temperature of the electric conductor may include a temperature of the current-carrying structure of the electric conductor, a temperature of a housing of the electric conductor or a temperature of an electric insulation of the electric conductor.

In some embodiments, the electric power system equipment is configured to operate at a mains frequency. In particular, the electric power system equipment may be configured to operate at a frequency of 16.7 Hz, of 25 Hz, of 50 Hz or of 60 Hz. The at least one flexible flap typically has a resonance frequency substantially equal to the mains frequency. Exemplarily, for an electric power system equipment configured to operate at a mains frequency of 16.7 Hz, the at least one flexible flap typically has a resonance frequency of substantially 16.7 Hz. For an electric power system equipment configured to operate at a mains frequency of 25 Hz, the at least one flexible flap typically has a resonance frequency of substantially 25 Hz. For an electric power system equipment configured to operate at a mains frequency of 50 Hz, the at least one flexible flap typically has a resonance frequency of substantially 50 Hz. For an electric power system equipment configured to operate at a mains frequency of 60 Hz, the at least one flexible flap typically has a resonance frequency of substantially 60 Hz.

In some embodiments, the electric power system equipment may be configured to operate at a plurality of mains frequencies. Exemplarily, the electric power system equipment may be an electric power system equipment of a railway vehicle capable of operating in a plurality of different railway electrification systems. For an electric power system equipment configured to operate at a plurality of mains frequencies, exemplarily at a first mains frequency and at a second mains frequency, the heat sink may have flexible flaps with a plurality of resonance frequencies, exemplarily, the heat sink may have first flexible flaps with a first resonance frequency substantially equal to the first mains frequency and second flexible flaps with a second resonance frequency substantially equal to the second mains frequency. Exemplarily, the electric power system equipment may be configured to operate at a mains frequency of 16.7 Hz and at a mains frequency of 50 Hz with the first resonance frequency being substantially 16.7 Hz and the second resonance frequency being substantially 50 Hz; or the electric power system equipment may be configured to operate at a mains frequency of 25 Hz and at a mains frequency of 60 Hz, and with the first resonance frequency being substantially 25 Hz and the second resonance frequency being substantially 60 Hz. In some embodiments, the electric power system equipment may be configured to operate at a mains frequency of 50 Hz and at a mains frequency of 60 Hz with the first resonance frequency being substantially 50 Hz and the second resonance frequency being substantially 60 Hz. Having flexible flaps with a plurality of resonance frequencies has the effect that for each of the plurality of resonance frequencies, the heat sink has an improved performance.

Typically, a method of cooling an electric conductor includes determining an alternating current (AC) frequency of a current flowing through the electric conductor. Typically, the AC frequency is determined by the operation scenario in which the electric conductor is employed or is to be employed. Exemplarily, the AC frequency may be the AC frequency of the electrical grid the electric conductor is electrically connected to or is configured to be electrically connected to. In some embodiments, determining the AC frequency may include measuring the AC frequency.

Typically, the method of cooling the electric conductor further includes providing a heat sink according to any of the embodiments described herein. Typically, the resonance frequency of at least one of the plurality of flexible flaps includes a resonance frequency substantially equal to the AC frequency. Providing the heat sink may include selecting a heat sink with flexible flaps having a resonance frequency substantially equal to the AC frequency. Typically, providing the heat sink includes selecting the heat sink based upon the heat generated by resistance heating of the electric conductor. In particular, the heat sink may be provided such that a reduction of the temperature of the electric conductor by at least 5 K may be achieved. Typically, selecting the heat sink includes determining the mounting conditions, in particular the mounting space and/or air flows within the vicinity of the electric conductor.

Typically, the method of cooling the electric conductor further includes establishing a thermal contact between the electric conductor and the heat sink. Establishing a thermal contact may include bringing the heat sink in physical contact with the electric conductor or with a housing of the electric conductor. In some embodiments, establishing a thermal contact may include employing a heat-transfer device. In some embodiments, establishing a thermal contact may include applying a heat-transfer medium.

Typically, the method of cooling the electric conductor further includes positioning the heat sink such that the magnet is arranged substantially perpendicular to the magnetic field generated by a current flowing through the electric conductor. Positioning the heat sink may include identifying the direction of the current flowing through the electric conductor. In some embodiments, in particular for more complex mounting conditions, exemplarily with a plurality of electric conductors at a close distance, positioning the heat sink may include determining the magnetic field, and in particular its expansion in the space adjacent to the electric conductor, generated by the current flowing through the electric conductor.

Typically, within this application and if not defined otherwise at a specific paragraph, features may be considered as being arranged substantially parallel if an angle between the features is smaller than 5°, and in particular smaller than 2°. Typically, within this application and if not defined otherwise at a specific paragraph, features may be considered as being arranged substantially perpendicular with each other if an angle between the features is larger than 85°, and in particular is larger than 88°, and is smaller than 95°, and in particular is smaller than 92°. Typically, within this application and if not defined otherwise at a specific paragraph, frequencies may be considered as being substantially the same if a ratio between the larger frequency and the smaller frequency does not exceed 1.05.

Embodiments of the present disclosure provide an improved cooling of electric conductors. The heat sink performance is improved by oscillating flexible flaps that are set to motion by an alternating magnetic field of the current flowing through the electric conductor. The present disclosure provides a passive improved heat sink with an increased convection through the fins of the heat sink. Cooling cost and design effort may be reduced. In particular, the present disclosure allows to improve the convection without an additional energy source being required and thus in a passive manner.

### BRIEF DESCRIPTION OF THE DRAWINGS

The accompanying drawings relate to embodiments of the disclosure and are described in the following:
FIG 1a schematically illustrates a heat sink according to embodiments described herein;
FIG 1b schematically illustrates an embodiment of a detail of the heat sink of FIG 1a;
FIG 1c schematically illustrates an embodiment of a detail of the heat sink of FIG 1a;
FIG 1d schematically illustrates the heat sink of Fig. 1a in a different perspective;
FIG 2 schematically illustrates a heat sink according to embodiments described herein;
FIG 3 schematically illustrates the heat sink of FIG 1a with additional optional features;
FIG 4 schematically illustrates an electric conductor in contact to a heat sink according to embodiments described herein;
FIG 5 schematically illustrates a switchgear in contact to a heat sink according to embodiments described herein;
FIG 6 schematically illustrates a method of cooling an electric conductor according to embodiments described herein.

### DETAILED DESCRIPTION OF EMBODIMENTS

Reference will now be made in detail to the various embodiments of the disclosure, one or more examples of which are illustrated in the figures. Generally, only the differences with respect to individual embodiments are described. Each example is provided by way of explanation of the disclosure and is not meant as a limitation of the disclosure. Further, features illustrated or described as part of one embodiment can be used on or in conjunction with other embodiments to yield a further embodiment. It is intended that the description includes such modifications and variations. In the figures, elements may be depicted with exaggerated dimensions to improve the comprehensibility of the detailed description of embodiments. Further, some elements may be depicted with enlarged dimensions while other elements in the same figure are depicted, relatively, with reduced dimensions.

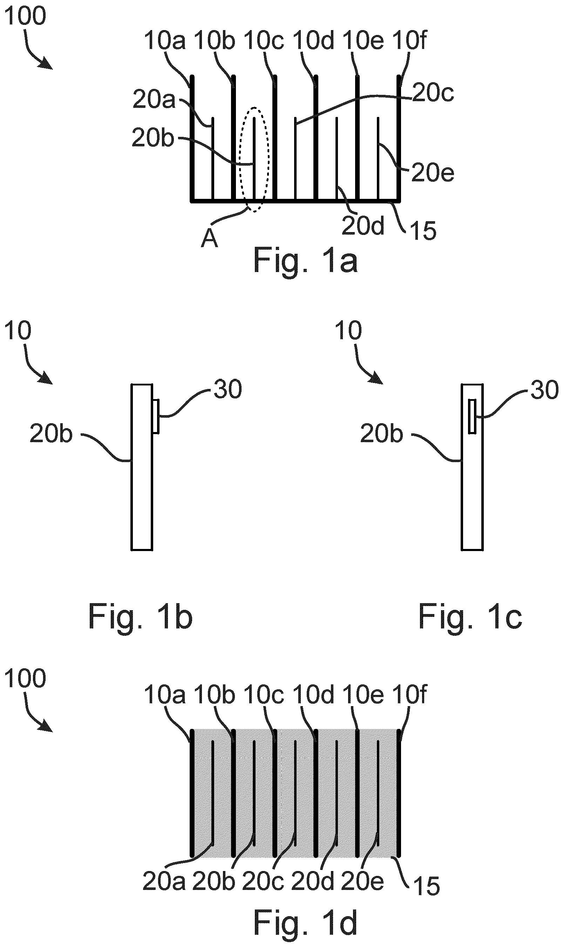

Fig. 1a schematically illustrates a heat sink 100. The heat sink has a plurality of fixed fins 10a-10f and a plurality of flexible flaps 20a-20e. The plurality of flexible flaps 20a-20e is arranged between the fixed fins 10a-10f. Between each pair of fixed fins 10a-10f, a flexible flap 20a-20e is arranged. In particular, between fixed fins 10a and 10b, flexible flap 20a is arranged; between fixed fins 10b and 10c, flexible flap 20b is arranged; between fixed fins 10c and 10d, flexible flap 20c is arranged; between fixed fins 10d and 10e, flexible flap 20d is arranged; and between fixed fins 10e and 10f, flexible flap 20e is arranged. In Fig. 1a, all fixed fins 10a-10f have the same fin length with respect to the base plate 15. All flexible flaps 20a-20e have the same flap length with respect to the base plate 15. The flexible flaps 20a-20e are supported by, in particular attached to, the base plate 15. The flexible flaps 20a-20e have a shorter length than the fixed fins 10a-10f.

Fig. 1b and Fig. 1c schematically illustrate a single flexible flap 20b of the heat sink, as marked in Fig. 1a by the cutout A. In Fig. 1b, a magnet 30 is attached to the flexible flap 20b. In particular, the magnet 30 is attached to a surface of the flexible flap 20b. In Fig. 1b, the magnet 30 is embedded in the flexible flap 20b. In particular, the magnet 30 is completely enclosed within the flexible flap 20b.

Fig. 1d schematically illustrates the heat sink 100 of Fig. 1a in a top view. In Fig. 1d, all fixed fins 10a-10f have the same fin width. All flexible flaps 20a-20e have the same flap width. The flexible flaps 20a-20e have a smaller width than the fixed fins 10a-10f. Overall, the flexible flaps 20a-20e do not extend beyond a contour defined by the fixed fins 10a-10f.

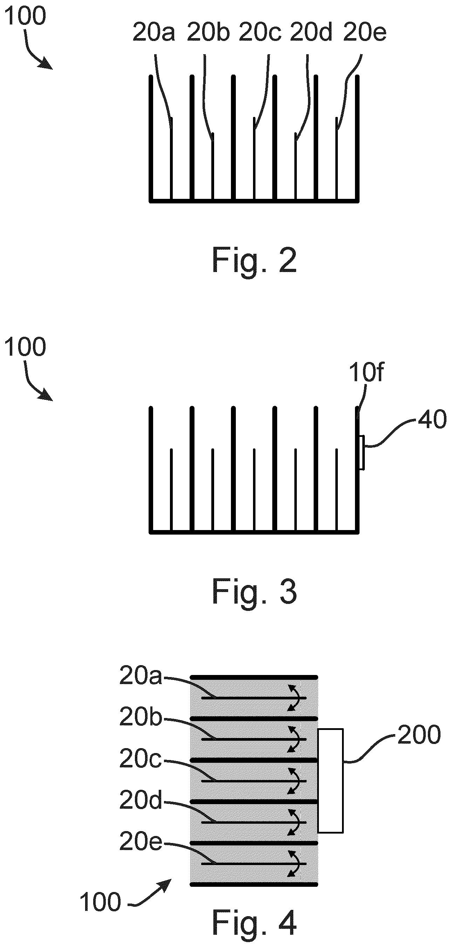

Fig. 2 schematically illustrates a heat sink 100. The heat sink 100 has a plurality of flexible flaps 20a-20e. The plurality of flexible flaps 20a-20e has a plurality of first flexible flaps 20a, 20c, 20e and a plurality of second flexible flaps 20b, 20d. The plurality of first flexible flaps 20a, 20c, 20e has a first length and the plurality of second flexible flaps 20b, 20d has a second length.

Fig. 3 schematically illustrates the heat sink 100 of Fig. 1a with an additional alignment magnet 40. The alignment magnet 40 is arranged at an outermost fixed fin 10f. In the embodiment shown in Fig. 3, the alignment magnet 40 is arranged on a side of the fixed fin 10f pointing away from the flexible flaps. However, in embodiments not shown in the figures, the alignment magnet 40 may be arranged on a side of the fixed fin 10f facing the flexible flaps. The alignment magnet 40 may be combined with the embodiment of Fig. 2 (combination not shown in the figures).

In Fig. 4, an electric conductor 200 in contact with the heat sink 100 is schematically shown. The flexible flaps 20a-20e of the heat sink 100 oscillate due to the magnetic field of an alternating current flowing in the electric conductor 200. In Fig. 4, the electric current flowing the electric conductor 200 is flowing substantially perpendicular to the drawing plane of Fig. 4.

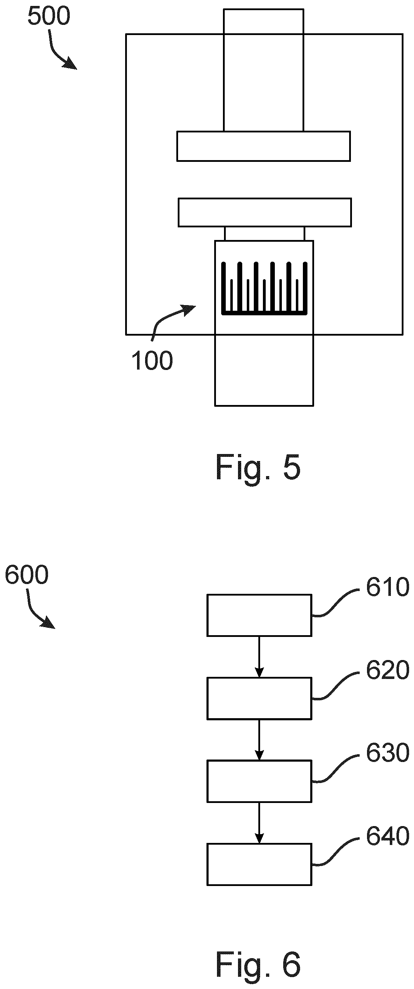

Fig. 5 schematically illustrates a switchgear 500 in thermal contact with the heat sink 100. In Fig. 5, the electric current flowing the switchgear 500, when the switchgear 500 electrically connects the upper and lower end of the switchgear, is flowing substantially parallel to the flexible flaps.

Fig. 6 schematically illustrates a method 600 of cooling an electric conductor. The method 600 includes determining 610 an alternating current, AC, frequency of a current flowing through the electric conductor. Subsequently, a heat sink is provided 620, wherein the resonance frequency of at least one of the plurality of flexible flaps of the heat sink is a resonance frequency substantially equal to the AC frequency. A thermal contact between the electric conductor and the heat sink is established 630 and the heat sink is positioned 640 such that the magnet is arranged substantially perpendicular to the magnetic field generated by a current flowing through the electric conductor. Establishing 630 a thermal contact between the electric conductor and the heat sink and positioning 640 the heat sink may be performed in any order. In particular, in embodiments not shown in Fig. 6, the heat sink may be positioned 640 prior to establishing 630 a thermal contact.

## Claims

1. A heat sink (100), comprising
a plurality of fixed fins (10a-10f);
a plurality of flexible flaps (20a-20e) arranged between the fixed fins (10a-10f);
wherein at least one of the flexible flaps (20a-20e) comprises a magnet (30) attached to or embedded in at least one of the flexible flaps (20a-20e).

2. The heat sink (100) of claim 1, wherein the flexible flaps (20a-20e) are positioned substantially parallel to the fixed fins (10a-10f).

3. The heat sink (100) of any of the preceding claims, wherein the flexible flaps (20a-20e) do not extend beyond a contour defined by the fixed fins (10a-10f).

4. The heat sink (100) of any of the preceding claims, wherein at least one of the flexible flaps (20a-20e) comprises a resonance frequency of substantially 16.7 Hz, 25 Hz, 50 Hz, or 60 Hz.

5. The heat sink (100) of any of the preceding claims, wherein the plurality of flexible flaps (20a-20e) comprises a first flexible flap and a second flexible flap; and wherein the first flexible flap comprises different properties than the second flexible flap.

6. The heat sink (100) of claim 5, wherein
the first flexible flap comprises a first resonance frequency and the second flexible flap comprises a second resonance frequency; and wherein the second resonance frequency is different from the first resonance frequency; and/or
wherein a first thickness of the first flexible flap is different from a second thickness of the second flexible flap; and/or
wherein a first length of the first flexible flap is different from a second length of the second flexible flap.

7. The heat sink (100) of any of the preceding claims, wherein at least one alignment magnet (40) is attached to or is embedded in at least one of the fixed fins (10a-10f).

8. The heat sink (100) of any of the preceding claims, wherein the magnet (30) and/or the alignment magnet (40) comprises a ferromagnetic material; and particularly comprises a permanent magnet.

9. An electric power system equipment comprising an electric conductor (200), wherein the heat sink (100) of any of the preceding claims is in thermal contact with the electric conductor (200).

10. The electric power system equipment of claim 9, wherein the electric conductor (200) comprises an electrical connection between components of the electric power system equipment.

11. The electric power system equipment of any of claims 9 to 10, wherein the electric power system equipment comprises a switchgear.

12. The electric power system equipment of any of claims 9 to 11, wherein an AC current passing through the electric conductor (200) causes at least one of the flexible flaps (20a-20e) to oscillate, and/or
wherein in operation, an oscillation of the flexible flaps (20a-20e) causes a reduction of a temperature of the electric conductor (200) of at least 5K.

13. The electric power system equipment of any of claims 9 to 12, wherein the permanent magnetic moment of the magnet (30) is arranged at an angle of at least 5° to the magnetic field generated by a current flowing through the electric conductor.

14. The electric power system equipment of any of claims 9 to 13, wherein the electric power system equipment is configured to be operated at a mains frequency and wherein the at least one flexible flap (20a-20e) comprises a resonance frequency substantially equal to the mains frequency.

15. A method (600) of cooling an electric conductor, the method comprising determining (610) an alternating current, AC, frequency of a current flowing through the electric conductor;
providing (620) a heat sink according to any of claims 1 to 8 wherein the resonance frequency of at least one of the plurality of flexible flaps comprises a resonance frequency substantially equal to the AC frequency;
establishing (630) a thermal contact between the electric conductor and the heat sink; and
positioning (640) the heat sink such that the magnet is arranged substantially perpendicular to the magnetic field generated by a current flowing through the electric conductor.
